(19)

Europäisches
Patentamt
European
Patent Office
Office européen
des brevets

(11) **EP 4 539 333 A1**

(12) **EUROPEAN PATENT APPLICATION**

(43) Date of publication:
**16.04.2025 Bulletin 2025/16**

(21) Application number: **23306791.7**

(22) Date of filing: **13.10.2023**

(51) International Patent Classification (IPC):
*H02P 21/14* (2016.01)    *H02P 21/16* (2016.01)

(52) Cooperative Patent Classification (CPC):
**H02P 21/141; H02P 21/16**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Schneider Toshiba Inverter Europe
SAS
27120 Pacy-sur-Eure (FR)**

(72) Inventors:
• **MROUEH, Mohamed
  27000 EVREUX (FR)**
• **JEBAI, Al Kassem
  27200 VERNON (FR)**
• **FRAPPÉ, Emmanuel
  92100 BOULOGNE-BILLANCOURT (FR)**

(74) Representative: **Plasseraud IP
104 Rue de Richelieu
CS92104
75080 Paris Cedex 02 (FR)**

(54) **METHODS FOR CONFIGURING A MOTOR DRIVE AND APPARATUSES FOR IMPLEMENTING THE SAME**

(57)    A method for driving an induction motor comprising a rotor and a magnetic core comprising a magnetic inductance component is provided, which comprises, by a motor drive configured for interfacing with the induction motor: performing a measurement of a voltage at terminals of the motor at standstill for a voltage measurement period during initial demagnetization of the magnetic core of the motor from an initial magnetic flux of the magnetic core, wherein the voltage measurement period is shorter than a time period of complete demagnetization of the magnetic core from the initial magnetic flux, and wherein the measurement of the voltage for the voltage measurement period comprises a plurality of $S$ voltage measurement data points $(v_i)_{1 \leq i \leq S}$, $S$ being a non-zero natural integer; determining a first magnetic flux estimate component based on the plurality of $S$ voltage measurement data points $(v_i)_{1 \leq i \leq S}$; determining a second magnetic flux estimate component by performing an exponential regression algorithm on the plurality of $S$ voltage measurement data points $(v_i)_{1 \leq i \leq S}$; and determining an estimate of the initial magnetic flux based on the first magnetic flux estimate and the second magnetic flux estimate component.

FIG. 3

EP 4 539 333 A1

**Description**

The present disclosure relates to the field of induction motors and their uses, in particular to apparatuses configured for driving an induction motor.

Induction motor drives are typically designed to operate with any induction motor, based on driving parameters which are determined during a measuring phase sometimes referred to as a "motor tuning" phase.

A motor drive is therefore generally not pre-configured so that it can be configured to operate with any motor drive to which it is coupled. As a consequence, a motor tuning phase typically involves performing measurements on the motor drive to determine estimates of tuning parameters or features of the induction motor to which the motor drive is coupled, and use of the determined tuning parameters and features for configuring the motor drive for driving the induction motor.

For example, tuning parameters or features such as the stator resistance, the leakage inductance, and the magnetizing curve of the induction motor may be determined in order to configure the motor drive and achieve an effective regulation of the induction motor. A precise determination of these parameters is desirable in order to optimize the motor behavior for greater effectiveness.

Therefore, tuning these parameters is a critical procedure during commissioning of a motor drive to be configured for driving a given induction motor.

There are two distinct types of tuning procedures of a motor drive for induction motors: rotational tuning, and standstill tuning. A rotational tuning is performed by rotating the motor, whereas a standstill tuning is performed while keeping the motor at standstill. The rotational tuning is known to produce more accurate estimates of the tuning parameters because more accurate measurements can be obtained on a rotating motor than that which can be obtained while the motor is kept at standstill.

However, starting an induction motor for purposes of measuring tuning parameters for configuring the motor drive to be used for driving the motor may constitute a constraint. As a consequence, the standstill tuning is known to be more convenient to use especially in situations where mechanical coupling constitutes a constraint (e.g. in cases where mechanical coupling is laborious to undo or redo).

Standstill tuning procedures of induction motors typically use Direct Current (DC) injections to magnetize the motor's inner magnetic core and analyze the response of the core. Analyzing the response involves performing measurements on the motor while at standstill. As a consequence, the quality of estimation of the tuning parameters depends on the accuracy of the measurements. However, measurement devices which provide accurate measurements even for very low values of measured quantities (such as voltage) - as such is typically the case for measurements performed on a motor at standstill - are not always available, which results in lower quality tuning of the motor at standstill.

There is therefore a need for providing improved schemes for configuring a motor drive and apparatuses implementing the same that address at least some of the above-described drawbacks and shortcomings of the conventional technology in the art.

It is an object of the present subject disclosure to provide improved schemes for configuring a motor drive and apparatuses implementing the same.

Another object of the present subject disclosure is to provide an improved scheme for configuring a motor drive and apparatus implementing the same for alleviating the above-described drawbacks and shortcomings of conventional schemes, in particular in that the proposed scheme for configuring a motor drive may be performed while the induction motor remains at standstill.

Yet another object of the present subject disclosure is to provide an improved scheme for configuring a motor drive and apparatus implementing the same for alleviating the above-described drawbacks and shortcomings of conventional schemes, in particular in that the proposed scheme for configuring a motor drive may be performed while the induction motor remains at standstill and the proposed scheme may be performed with standard-grade measuring equipment.

To achieve these objects and other advantages and in accordance with the purpose of the present subject disclosure, as embodied and broadly described herein, in one aspect of the present subject disclosure, a method for configuring a motor drive for driving an induction motor comprising a rotor and a magnetic core comprising a magnetic inductance component (e.g. an asynchronous induction motor) is proposed. The method comprises, by a motor drive configured for interfacing with the induction motor: performing a measurement of a voltage at terminals of the motor at standstill for a voltage measurement period during initial demagnetization of the magnetic core of the motor from an initial magnetic flux of the magnetic core, wherein the voltage measurement period is shorter than a time period of complete demagnetization of the magnetic core from the initial magnetic flux, and wherein the measurement of the voltage for the voltage measurement period comprises a plurality of S voltage measurement data points $(v_i)_{1 \leq i \leq S}$, $S$ being a non-zero natural integer; determining a first magnetic flux estimate component based on the plurality of $S$ voltage measurement data points $(v_i)_{1 \leq i \leq S}$; determining a second magnetic flux estimate component by performing an exponential regression algorithm on the plurality of $S$ voltage measurement data points $(v_i)_{1 \leq i \leq S}$; and determining an estimate of the initial magnetic flux based on the first magnetic flux estimate and the second magnetic flux estimate component.

The proposed method advantageously provides a scheme that may be used for configuring a motor drive in order to drive an induction motor coupled to the motor drive while keeping the motor drive at standstill and using standard-grade measuring equipment. This advantageously avoids starting the induction motor for the (sole) purpose of determining parameters of the motor drive that corresponds to measurements performed on the motor drive, and allows performing standstill tuning of an induction motor using standard-grade measuring equipment.

In particular, the proposed method may advantageously be used for determining an estimate of the magnetizing curve of an induction motor by performing standstill tuning of the induction motor.

In one or more embodiments, the proposed method may further comprise: configuring the motor drive based on the estimate of the initial magnetic flux.

In one or more embodiments, the proposed method may further comprise: determining an estimate ($\hat{\tau}_0$) of a time constant of the rotor of the motor using the exponential regression algorithm, wherein the second magnetic flux estimate component is determined based on the estimate ($\hat{\tau}_0$) of the time constant of the rotor of the motor.

In one or more embodiments, the measurement of the voltage for the voltage measurement period may comprise a plurality of $S$ voltage measurement data points ($v_i$)$_{1 \leq i \leq S}$, $S$ being a non-zero natural integer, and the second magnetic flux estimate component may be determined based on a combination of the estimate ($\hat{\tau}_0$) of the time constant of the rotor of the motor with one or more voltage measurement data points of the plurality of $S$ voltage measurement data points ($v_i$)$_{1 \leq i \leq S}$ selected in the neighborhood of the last voltage measurement point ($v_S$).

In one or more embodiments, the measurement of the voltage for the voltage measurement period may comprise a plurality of $S$ voltage measurement data points ($v_i$)$_{1 \leq i \leq S}$, $S$ being a non-zero natural integer, and the proposed method may further comprise: determining an average voltage value ($\tilde{v}_S$) averaging a plurality of voltage measurement data points of the plurality of $S$ voltage measurement data points ($v_i$)$_{1 \leq i \leq S}$ (in the neighborhood among the plurality of $S$ voltage measurement data points ($v_i$)$_{1 \leq i \leq S}$ of the last voltage measurement point ($v_S$)), and the second magnetic flux estimate component may be determined based on the average voltage value.

In one or more embodiments, each of the plurality of voltage measurement data points may be comprised in a set of $\{v_{S+k}\}_{-K \leq k \leq 0}$, wherein K is a non-zero natural integer.

In one or more embodiments, the measurement of the voltage for the voltage measurement period may comprise a plurality of $S$ voltage measurement data points ($v_i$)$_{1 \leq i \leq S}$, $S$ being a non-zero natural integer, and the proposed method may further comprise: determining an average voltage value ($\tilde{v}_S$) averaging a plurality of voltage measurement data points of the plurality of S voltage measurement data points ($v_i$)$_{1 \leq i \leq S}$ by:

$$\tilde{v}_S = \frac{1}{2K} \sum_{-K \leq k \leq K} v_{S+k}$$

The second magnetic flux estimate component may be based on the average voltage value $\tilde{v}_S$.

In one or more embodiments, the measurement of the voltage for the voltage measurement period may comprise a plurality of $S$ voltage measurement data points ($v_i$)$_{1 \leq i \leq S}$, $S$ being a non-zero natural integer, the $S$ voltage measurement data points ($v_i$)$_{1 \leq i \leq S}$ may be obtained through measurement sampling with a sampling interval ($\Delta t$), and the first magnetic flux estimate component may be determined based on a combination of the sampling interval with a combination of one or more of the $S$ voltage measurement data points ($v_i$)$_{1 \leq i \leq S}$.

In one or more embodiments, the first magnetic flux estimate component may be determined based on the combination $\Delta t \cdot \sum_{i=1}^{S} v_i$.

In one or more embodiments, the measurement of the voltage for the voltage measurement period may comprise a plurality of $S$ voltage measurement data points ($v_i$)$_{1 \leq i \leq S}$ $S$ being a non-zero natural integer, and the method may further comprise: determining an estimate ($\hat{\tau}_0$) of a time constant of the rotor of the motor using the exponential regression algorithm. The $S$ voltage measurement data points ($v_i$)$_{1 \leq i \leq S}$ may be obtained through voltage measurement sampling with a sampling interval ($\Delta t$), the first magnetic flux estimate component may be determined based on the combination $\Delta t \cdot \sum_{i=1}^{S} v_i$, the second magnetic flux estimate component may be determined based on the combination $\hat{\tau}_0 \tilde{v}_S$, the voltage value $\tilde{v}_S$ may be determined based on one or more voltage measurement data points of the plurality of $S$ voltage measurement data points ($v_i$)$_{1 \leq i \leq S}$ selected in the neighborhood of the last voltage measurement point ($v_S$), and the estimate of the initial magnetic flux may be determined based on combination of the first magnetic flux estimate with the second magnetic flux estimate component.

In one or more embodiments, the measurement of the voltage for the voltage measurement period may comprise a plurality of $S$ voltage measurement data points ($v_i$)$_{1 \leq i \leq S}$, $S$ being a non-zero natural integer, and the integer $S$ may be predefined based on a multiple of a primary estimate of the rotor time constant.

In one or more embodiments, the motor is an asynchronous induction motor.

In yet another aspect of the present subject disclosure, an apparatus is proposed, which comprises a processor, a memory operatively coupled to the processor, and an interface for coupling to an induction motor to be driven by the apparatus, wherein the apparatus is configured to perform a method as proposed in the present subject disclosure.

In yet another aspect of the present subject disclosure, a non-transitory computer-readable medium encoded with executable instructions which, when executed, causes an apparatus comprising a processor operatively coupled with a memory, to perform a method as proposed in the present subject disclosure, is proposed.

In yet another aspect of the present subject disclosure, a computer program product comprising computer program code tangibly embodied in a computer readable medium, said computer program code comprising instructions to, when provided to a computer system and executed, cause said computer to perform a method as proposed in the present subject disclosure, is proposed. In another aspect of the present subject disclosure, a data set representing, for example through compression or encoding, a computer program as proposed herein, is proposed.

It should be appreciated that the present subject disclosure can be implemented and utilized in numerous ways, including without limitation as a process, an apparatus, a system, a device, and as a method for applications now known and later developed. These and other unique features of the system disclosed herein will become more readily apparent from the following description and the accompanying drawings.

## Brief description of the drawings

The present subject disclosure will be better understood and its numerous objects and advantages will become more apparent to those skilled in the art by reference to the following drawings, in conjunction with the accompanying specification, in which:

Figure 1 illustrates an exemplary motor drive in a drive-motor system to which the proposed methods may be applied according to one or more embodiments;

Figure 2 illustrates an exemplary model of a standstill induction motor that may be used in one or more embodiments of the present subject disclosure;

Figure 3 illustrates an exemplary scheme for configuring a motor drive according to one or more embodiments of the present subject disclosure;

Figure 4 illustrates an exemplary magnetic saturation model through four saturation model curves according to one or more embodiments;

Figure 5a illustrates the magnetization of the main inductance $L$ of an induction motor in which a DC current is injected according to one or more embodiments;

Figure 5b illustrates the demagnetization of the main inductance $L$ of the induction motor according to one or more embodiments;

Figure 6 shows an exemplary voltage-time curve that illustrates a demagnetization process of a motor magnetic core of an induction motor according to one or more embodiments;

Figure 7 illustrates an apparatus according to one or more embodiments; and

Figure 8 illustrates performances of the proposed method.

## Description of embodiments

For simplicity and clarity of illustration, the drawing figures illustrate the general manner of construction, and descriptions and details of well-known features and techniques may be omitted to avoid unnecessarily obscuring the discussion of the described embodiments of the invention. Additionally, elements in the drawing figures are not necessarily drawn to scale. For example, the dimensions of some of the elements in the figures may be exaggerated relative to other elements to help improve understanding of embodiments of the present invention. Certain figures may be shown in an idealized fashion in order to aid understanding, such as when structures are shown having straight lines, sharp angles, and/or parallel planes or the like that under real-world conditions would likely be significantly less symmetric and orderly. The same reference numerals in different figures denote the same elements, while similar reference numerals may, but do not necessarily, denote similar elements.

In addition, it should be apparent that the teaching herein can be embodied in a wide variety of forms and that any specific structure and/or function disclosed herein is merely representative. In particular, one skilled in the art will appreciate that an aspect disclosed herein can be implemented independently of any other aspects and that several aspects can be combined in various ways.

The present disclosure is described below with reference to functions, engines, block diagrams and flowchart illustrations of the methods, systems, and computer program according to one or more exemplary embodiments. Each described function, engine, block of the block diagrams and flowchart illustrations can be implemented in hardware, software, firmware, middleware, microcode, or any suitable combination thereof. If implemented in software, the functions, engines, blocks of the block diagrams and/or flowchart illustrations can be implemented by computer program instructions or software code, which may be stored or transmitted over a computer-readable medium, or loaded onto a general purpose computer, special purpose computer or other programmable data processing apparatus to produce a machine, such that the computer program instructions or software code which execute on the computer or other programmable data processing apparatus, create the means for implementing the functions described herein.

Embodiments of computer-readable media includes, but are not limited to, both computer storage media and communication media including any medium that facilitates transfer of a computer program from one place to another. As used herein, a "computer storage media" may be any physical media that can be accessed by a computer or a processor. In addition, the terms « memory » and « computer storage media" include any type of data storage device, such as, without limitation, a hard drive, a flash drive or other flash memory devices (e.g. memory keys, memory sticks, key drive, SSD drives), CD-ROM or other optical storage, DVD, magnetic disk storage or other magnetic storage devices, memory chip(s), Random Access Memory (RAM), Read-Only-Memory (ROM), Electricallyerasable programmable read-only memory (EEPROM), smart cards, or any other suitable medium that can be used to carry or store program code in the form of instructions or data structures which can be read by a computer processor, or a combination thereof. Also, various forms of computer-readable media may transmit or carry instructions to a computer, including a router, gateway, server, or other transmission device, wired (coaxial cable, fiber, twisted pair, DSL cable) or wireless (infrared, radio, cellular, microwave). The instructions may comprise code from any computer-programming language, including, but not limited to, assembly, C, C++, Python, Visual Basic, SQL, PHP, and JAVA.

Unless specifically stated otherwise, it will be appreciated that throughout the following description discussions utilizing terms such as processing, computing, calculating, determining, or the like, refer to the action or processes of a computer or computing system, or similar electronic computing device, that manipulate or transform data represented as physical, such as electronic, quantities within the registers or memories of the computing system into other data similarly represented as physical quantities within the memories, registers or other such information storage, transmission or display devices of the computing system.

As used herein, the terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

Additionally, the word "exemplary" is used herein to mean "serving as an example, instance, or illustration". Any embodiment or design described herein as "exemplary" is not necessarily to be construed as preferred or advantageous over other embodiments or designs.

In the present subject disclosure, the terms "coupled" and "connected", along with their derivatives, may be indifferently used to indicate that two or more elements are in direct physical or electrical contact with each other, or two or more elements are not in direct contact with each other, but yet still co-operate or interact with each other.

It should be understood that embodiments of the present subject disclosure may be used for configuring an induction motor drive configured for driving an induction motor, in particular, although not limited to, an induction motor drive configured for driving an asynchronous induction motor.

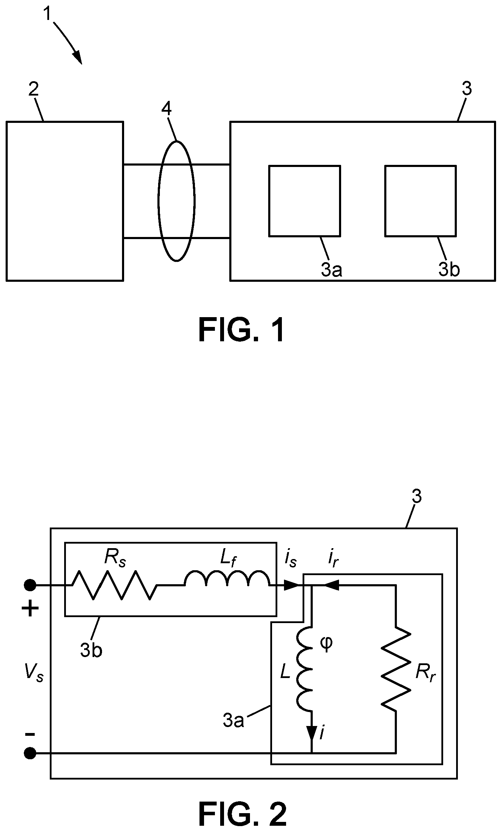

Figure 1 shows an exemplary motor drive in a drive-motor system (1) to which the proposed methods may be applied according to one or more embodiments.

Shown on Fig. 1 is a drive-motor system (1) comprising a motor drive (2) and an induction motor (3) which are operatively coupled with each other through an interface (4).

The induction motor (3) comprises a rotor (3a) and a magnetic core (3b) which comprises a magnetic induction component (not shown on the figure), sometimes referred to as the "main induction" of the induction motor (3).

In some embodiments, a so-called "motor tuning" phase may be performed for determining configuration parameters of the motor drive (2) that corresponds to characteristics of the induction motor (3) so that the motor drive (2) be tuned for driving the induction motor (3).

Depending on the embodiment, the motor drive (2) may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

As the proposed methods aim at being used for configuring an induction motor drive coupled to an induction motor at standstill, a model of a standstill induction motor may advantageously be considered.

Figure 2 shows an exemplary model of a standstill induction motor that may be used in one or more embodiments of the present subject disclosure.

Shown on Fig. 2 is an exemplary inverse Γ-model of a standstill induction motor.

The standstill induction motor is modelled by a dipole circuit (3) to which a voltage Vs may be applied for starting the motor. The model includes a first block (3b) modelling a stator of the motor (3) which is serially coupled to a second block (3a) modelling a rotor of the motor (3). In the illustrated example of Fig. 1, the first block (3b) comprises a stator

resistor $R_s$ serially couple with a leakage inductance $L_f$, and the second block (3a) comprises rotor resistor $R_r$ coupled in parallel with a main inductance $L$ of the motor (3).

As shown on Fig. 2, a current $i_s$ that is injected in the motor (3) flows through the first block (3b), and then through the main inductance $L$ of the motor (3). The current $i_s$ is summed with a current $i_r$ that flows through the rotor resistance $R_r$, resulting in a current $i = i_s + i_r$ (according to Kirchhoff's circuit law for currents flowing in and out a node of an electrical circuit) flowing through the main inductance $L$ of the motor (3).

Assuming that the induction motor is at a standstill, the following sets of equations may be derived from the model of Fig. 2:

Equations along the d-axis:

$$V_{sd} = R_s i_{sd} + L_f \frac{di_{sd}}{dt} + \frac{d\varphi_d}{dt}$$

$$0 = R_r i_{rd} + \frac{d\varphi_d}{dt}$$

$$\varphi_d = L(i_{sd} + i_{rd})$$

where $V_{sd}$ is the projection on the d-axis of the input voltage $V_s$, $R_s$ is the stator resistance, $i_{sd}$ is the projection on the d-axis of a current $i_s$ injected to the motor, $L_f$ is a leakage inductance of the stator, $R_r$ is the rotor resistance, $i_{rd}$ is the projection on the d-axis of a current $i_r$ flowing through the rotor resistance $R_r$, and $\varphi_d$ is the projection on the d-axis of the magnetic flux $\varphi$ generated by the main inductance $L$ of the rotor through which a current $i = i_{sd} + i_{rd}$ flows.

Equations along the q-axis:

$$V_{sq} = R_s i_{sq} + L_f \frac{di_{sq}}{dt} + \frac{d\varphi_q}{dt}$$

$$0 = R_r i_{rq} + \frac{d\varphi_q}{dt}$$

$$\varphi_d = L(i_{sq} + i_{rq})$$

where $V_{sq}$ is the projection on the d-axis of the input voltage $V_s$, $R_s$ is the stator resistance, $i_{sq}$ is the projection on the d-axis of a current $i_s$ injected to the motor, $L_f$ is a leakage inductance of the stator, $R_r$ is the rotor resistance, $i_{rq}$ is the projection on the d-axis of a current $i_r$ flowing through the rotor resistance $R_r$, and $\varphi_q$ is the projection on the d-axis of the magnetic flux $\varphi$ generated by the main inductance $L$ of the rotor through which a current $i = i_{sq} + i_{rq}$ flows.

As can be seen above, the equations along the d-axis and along the q-axis represent two identical systems, one along the d-axis and the other along the q-axis, evolving with no link between them. Each of these two systems can therefore be modelled as an inverse-Γ induction motor model, such as the exemplary model illustrated by Fig. 2.

As a consequence, the proposed scheme may be described using this exemplary model as applied for one or the other axis, so that the equations for one or the other axis may indifferently be used, as the proposed scheme may be used with either set of equations. In the following, as an example, the above set of equations corresponding to orienting the frame along the d-axis will be used, so that the model used can be narrowed down to one inverse- circuit.

In the following, the proposed scheme is described based on the exemplary model of an induction motor at standstill of Fig. 2 assuming a frame oriented along the d-axis. However, a person skilled in the art would understand that, even though the present description refers to the inverse Γ-model of a standstill induction motor with a frame oriented along the d-axis as an example of model of a standstill induction motor that may be used in one or more embodiments, the inverse Γ-model of a standstill induction motor with a frame oriented along the q-axis may be used in place of the inverse Γ-model of a standstill induction motor with a frame oriented along the d-axis, which is given by way of an example only.

Furthermore, in the following, the proposed scheme is described based on the exemplary model of an induction motor at standstill of Fig. 2. However, a person skilled in the art would understand that, even though the present description refers to the inverse Γ-model of a standstill induction motor as an example of model of a standstill induction motor that may be used in one or more embodiments, any other suitable model of a standstill induction motor may be used in place of the inverse Γ-model of a standstill induction motor of Fig. 2, which is given by way of an example only.

Referring back to Figs. 1 and 2, in one or more embodiments, at least one configuration parameters for configuring the motor drive (2) for driving the induction motor (3) may be obtained through determining an estimate of the magnetizing curve of the magnetic core of the induction motor (3).

As a consequence, the proposed scheme advantageously provides a method for determining an estimate of the magnetizing curve of the magnetic core of the induction motor (3) while keeping the motor at standstill based on voltage measurements which may be performed with a standard-grade measurement equipment.

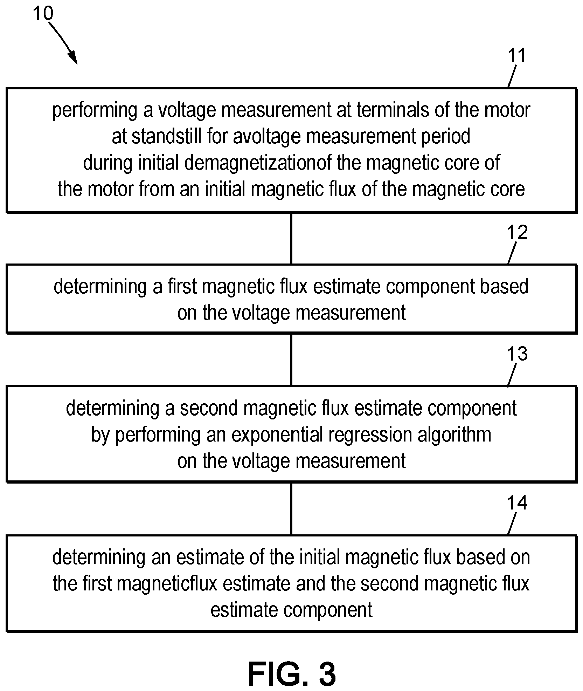

Figure 3 is a diagram that illustrates an exemplary scheme (10) for configuring a motor drive according to one or more embodiments of the present subject disclosure.

One considers a motor drive coupled to an induction motor, such as illustrated on Fig. 1 for which data related to configuration parameters usable for configuring the motor drive for driving the motor may be determined according to the proposed scheme.

The motor to which the motor drive is coupled may in some embodiments be modeled by a standstill induction motor model such as described herein in relation with the example of Fig. 2.

Further, as illustrated in Fig. 1 and Fig. 2, the motor to be driven by the motor drive once configured may comprise a rotor and a magnetic core comprising a magnetic inductance component.

In one or more embodiments, a measurement of a voltage at terminals of the motor at standstill may be performed (11) for a voltage measurement period during demagnetization of the magnetic core of the motor from an initial magnetic flux of the magnetic core (a period of time during which a demagnetization phenomenon of the magnetic core occurs) of the motor.

In some embodiments, the measurement of voltage may be performed during initial demagnetization of the magnetic core of the motor, that is, during an initial portion of the period of time during which a demagnetization phenomenon of the magnetic core occurs further to magnetization of the magnetic core at the initial magnetic flux value.

In some embodiments, the voltage measurement period may be shorter than a time period of complete demagnetization of the magnetic core from the initial magnetic flux, so that the proposed scheme advantageously does not require performing the voltage measurement for a time period of substantially the same duration as that of the time period for complete demagnetization of the magnetic core from the initial magnetic flux. Therefore, the voltage measurement at the motor's terminals during demagnetization of the magnetic core can advantageously be interrupted, instead of performing the voltage measurement for the entire time period of complete demagnetization of the core.

In some embodiments, the measurement of the voltage performed during the voltage measurement period may comprise a plurality of $S$ voltage measurement data points $(v_i)_{1 \leq i \leq S}$, $S$ being a non-zero natural integer.

For example, in some embodiments, the $S$ voltage measurement data points $(v_i)_{1 \leq i \leq S}$ may be obtained through voltage measurement sampling with a sampling interval $(\Delta t)$. In such embodiments, the voltage at the motor's terminals may be measured during a voltage measurement period which is substantially equal to the product of the number of voltages samples and the sampling interval: $S \cdot \Delta t$.

According to the present subject disclosure, the voltage measurement which is performed during demagnetization of the magnetic core of the motor may be used to apply two different induced voltage measurement processing methods. Accordingly, the proposed scheme may be viewed as an hybrid scheme that combines two different induced voltage measurement processing methods.

In one or more embodiments, an integration analysis voltage measurement processing method may be used to integrate the value(s) of the measured voltage over the time period during which the measurement is performed, which may result in a first magnetic flux estimate component:

In one or more embodiments, a first magnetic flux estimate component may be determined (12) based on the voltage measurement. In some embodiments, the first magnetic flux estimate component may be determined based on the plurality of $S$ voltage measurement data points $(v_i)_{1 \leq i \leq S}$ generated through the voltage measurement.

In one or more embodiments, an exponential regression analysis voltage measurement processing method may be used to fit an exponential decreasing curve on the voltage measurement. Once the fitting curve has been determined, it may advantageously be used to integrate the voltage over the period of time during which no measurement was performed, for a second portion of the demagnetization process that follows the first portion during which voltage measurement was performed. This may result in a second magnetic flux estimate component:

In one or more embodiments, a second magnetic flux estimate component may be determined (13) by performing an exponential regression algorithm on the voltage measurement. For example, an exponential regression algorithm may be performed on one or more of the plurality of $S$ voltage measurement data points $(v_i)_{1 \leq i \leq S}$.

According to the proposed hybrid scheme, in one or more embodiments, an estimate of the initial magnetic flux may be determined (14) based on the first magnetic flux component and the second magnetic flux estimate component.

In one or more embodiments, the motor drive may be configured for driving the induction motor based on the estimate of the initial magnetic flux of the magnetic core of the motor.

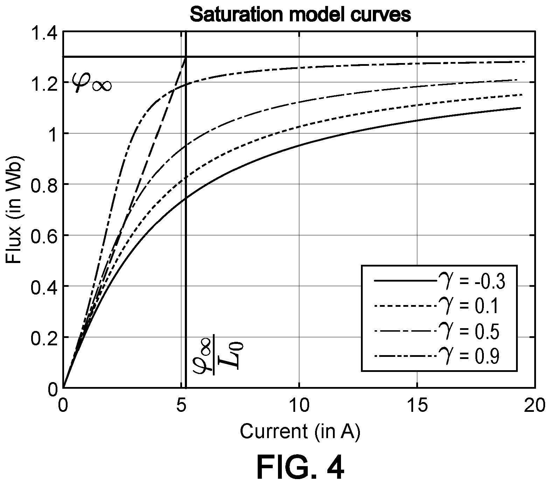

In one or more embodiments, magnetic saturation of the magnetic core of the motor to be driven further to injecting to the motor a DC current may be taken into account in the proposed scheme through the standstill induction motor model which has been chosen as model of the induction motor to be driven. For example, referring to Fig. 2, the main inductance $L$ in the inverse-$\Gamma$ model circuit shown on Fig. 2 may experience magnetic saturation, so that the magnetic flux of the magnetic core generated by injecting a DC current to the motor may increase, as the value of the injected current is increased, up to a certain ceiling value $\varphi_\infty$ which corresponds to a saturation magnetic flux value. That is, the relation between the current $i$ inputted to the motor and the magnetic flux $\varphi$ generated by the magnetic core of the motor is not linear for values beyond a certain injected current value, as illustrated in Fig. 4.

In one or more embodiments, a magnetic saturation model may therefore advantageously be considered in order to distinguish between the induction motor operating in linear regime (no magnetic saturation of the magnetic core), and the induction motor operating in saturation regime (occurrence of magnetic saturation of the magnetic core), for example to capture parameters or features of the motor operating in linear phase (linear regime), versus parameters or features of the motor operating in magnetic saturation phase (saturation regime).

It is indeed advantageous to configure the drive so that the motor is driven with one or more current values which do not trigger magnetic saturation of the magnetic core of the motor.

In some embodiments, a magnetic core magnetization model that takes into account magnetic saturation of the core (sometimes referred herein to as a "magnetic saturation model"), which defines the relation between the current injected to the induction motor and the flux value in the main inductance of the induction motor, may be considered to estimate parameters of the induction motor that characterize the motor operating in linear phase (linear regime) (versus the motor operating in magnetic saturation phase (saturation regime)).

For example, in some embodiments, the following magnetic saturation model $i = f(\varphi)$ of an induction motor may be used for characterizing the motor operating in linear phase linear regime):

$$i = \frac{\varphi}{L_0} \cdot \frac{1 - \gamma \dfrac{\varphi}{\varphi_\infty}}{1 - \left(\dfrac{\varphi}{\varphi_\infty}\right)^2}$$

where $\varphi_\infty$ designates the maximal magnetic flux that can be induced in the core (that may be seen as corresponding to the magnetic saturation flux generated by the main inductance assuming an infinite current injected in the motor), $L_0$ designates the linear inductance before saturation (that may be seen as corresponding to the value of the main inductance of the motor operating in linear phase (linear regime) (versus the motor operating in magnetic saturation phase (saturation regime))), and $\gamma$ designates a unitless shape factor that impacts the flux value at which the magnetization switches from the linear regime to the saturated regime. The transition flux value may be equal to $\gamma \varphi_\infty$ ($\gamma < 1$).

The magnetic saturation model may therefore in some embodiments be a parametric model with three parameters (e.g., in the exemplary case of the above model: $\varphi_\infty$, $L_0$, and $\gamma$).

Figure 4 illustrates the magnetic saturation model through four saturation model curves respectively corresponding to four values of the $\gamma$ parameter of the saturation model (the other two parameters having fixed values: $\varphi_\infty$ = 1.3 $Wb$ and $L_0$ = 250$mH$).

In the following, the proposed scheme is described based on the exemplary parametric magnetic saturation model of an induction motor at standstill of Fig. 4 governed by the three parameters $\varphi_\infty$, $L_0$, and $\gamma$. However, a person skilled in the art would understand that, even though the present description refers to the parameters of this exemplary magnetic saturation model, any other suitable magnetic saturation model of an induction motor, such as, for example, may be used in place of the parametric magnetic saturation model of an induction motor at standstill of Fig. 4, which is given by way of an example only.

In one or more embodiments, a plurality of voltage data points may be measured during demagnetization of the magnetic core of the motor, further to performing a DC injection, that is, injecting a DC current in the motor at standstill for magnetizing the magnetic core to a so-called initial magnetic flux level. In some embodiments, a certain current may be injected for a given period of time in order to magnetize the inner core of the motor and, afterward, the circuit may be opened, and the voltage measurement performed on the open circuit. The induced voltage during demagnetization may be analyzed according to the proposed hybrid scheme in order to obtain an estimate of the magnetic flux resulting from the DC injection.

The estimate of the initial magnetic flux determined according to the proposed scheme may be used in some embodiments for generating a duplet $(i, \varphi)$, where $i$ is the DC current that was injected in the motor for magnetizing the magnetic core, and $\varphi$ is the magnetic flux of the core resulting from the magnetization thereof.

For example, a plurality of N voltage measurements may be performed, and each of the N voltage measurements

$(V_{sj})_{1\le j\le N}$ may be preceded by a DC current injection $i_j$ of respective level, so that N duplets $(i_j, V_{sj})_{1\le j\le N}$ of injected DC current value and measured voltage value may be determined.

In one or more embodiments, each voltage measurement $V_{sj}$ may further be used to determine according to the proposed hybrid scheme a corresponding magnetic flux value $\varphi_j$ of magnetic flux in the main inductance of the motor, so that N magnetic flux values $(\varphi_j)_{1\le j\le N}$ may be determined based on the N voltage measurements $(V_{sj})_{1\le j\le N}$ according to the proposed hybrid scheme.

In some embodiments, the N magnetic flux values $(\varphi_j)_{1\le j\le N}$ may be used to determining a plurality of N duplets $(i_j,\varphi_j)_{1\le j\le N}$ of injected DC current and magnetic flux values, based on the N voltage measurements $(V_{sj})_{1\le j\le N}$ performed further to injecting respective values $i_j$ of DC current in the motor at standstill for respective time periods.

In one or more embodiments, a Direct Current, DC, current injection in the motor at standstill may be performed prior to performing the voltage measurement, for magnetization of the magnetic core of the motor before opening the electrical circuit of the motor and performing the voltage measurement on the open circuit (at the motor's terminals) during demagnetization of the magnetic core.

For example, in some embodiments, the voltage measurement at motor terminals of the motor at standstill during demagnetization of the magnetic core of the motor may be performed following a DC current injection of a respective value of DC current in the motor at standstill performed for a respective DC injection time duration, so that the magnetic core of the motor may be magnetized to an initial magnetic flux when the voltage measurement is performed.

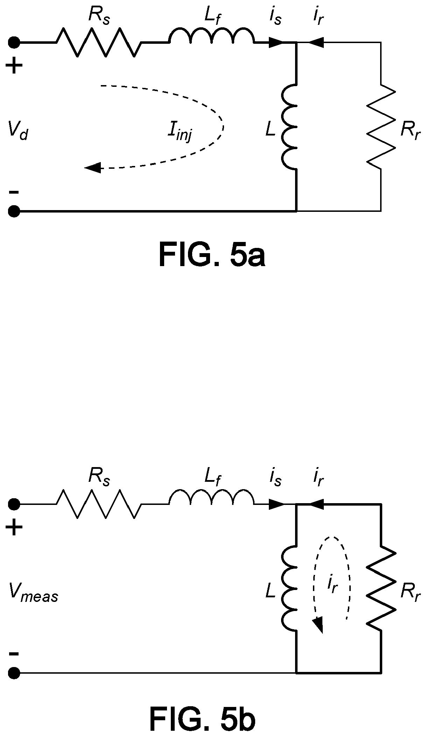

Figure 5a shows the injection of a DC current $I_{inj}$ in an induction motor (modeled by the exemplary inverse-Γ model of the induction motor at standstill illustrated by Fig. 2) in order to generate magnetization of the main inductance L of the motor, that is, to generate an initial magnetic flux in the main inductance $L$ of the motor. During the DC current injection, the main inductance $L$ of the motor becomes magnetized at a magnetic flux level which depends on one or more of the level of the injected DC current and the duration of the DC current injection.

Referring to Fig. 2 and Fig. 5a, during injection of the DC current $I_{inj}$ in the motor, a current $i_s$ may flow in the serially coupled stator resistance $R_s$ and leakage inductance $L_f$ block (3b in Fig. 2) and the main inductance $L$ of the motor, and no current may flow in the rotor resistance $R_r$ of the motor. When imposing a constant voltage on the motor's terminals, the input current may eventually stabilize in the main inductance L after a certain time period.

In one or more embodiments, once the DC current injection is stopped, the electrical circuit of the motor may be opened at the positive and negative poles, and the voltage $V_{meas}$ at the motor terminals corresponding to the poles of the motor at standstill may be measured.

Figure 5b shows the demagnetization of the main inductance $L$ of the motor (modeled by the exemplary inverse-Γ model of the induction motor at standstill illustrated by Fig. 2) once the DC current $I_{inj}$ is no longer injected and the circuit of the motor is opened.

Referring to Fig. 2 and Fig. 5b, once the DC current $I_{inj}$ is no longer injected in the motor and the circuit is opened, the current $i_s$ may no longer flow in the serially coupled stator resistance $R_s$ and leakage inductance $L_f$ block (3b in Fig. 2) and the main inductance $L$ of the motor, and a current $i_r$ (induced by the magnetized magnetic core of the motor) may instead flow in the parallel coupled rotor resistance $R_r$ and main inductance $L$ of the motor. Once the circuit is opened, a demagnetization process starts between the main inductance $L$ and the rotor resistance $R_r$ from the initial magnetic flux (which corresponds to the magnetic flux level that was reached by magnetization of the core, e.g. through a prior DC injection). At this point, the measured voltage $V_{meas}$ corresponds to the voltage across the main inductance $L$ because no current is flowing through the stator resistance $R_s$ and the leakage inductance $L_f$:

$$V_{meas}(t) = \frac{d\varphi}{dt}(t)$$

A voltage measurement $V_{meas}$ of the voltage at the terminals of the motor may therefore advantageously reflect the magnetic flux $\varphi$ of the main inductance $L$ of the motor.

During the demagnetization process, the magnetic flux in the motor magnetic core may be governed by the following differential equation:

$$0 = R_r \frac{\varphi(t)}{L_0} \frac{1 - \gamma \frac{\varphi(t)}{\varphi_\infty}}{1 - \left(\frac{\varphi(t)}{\varphi_\infty}\right)^2} + \frac{d\varphi}{dt}(t)$$

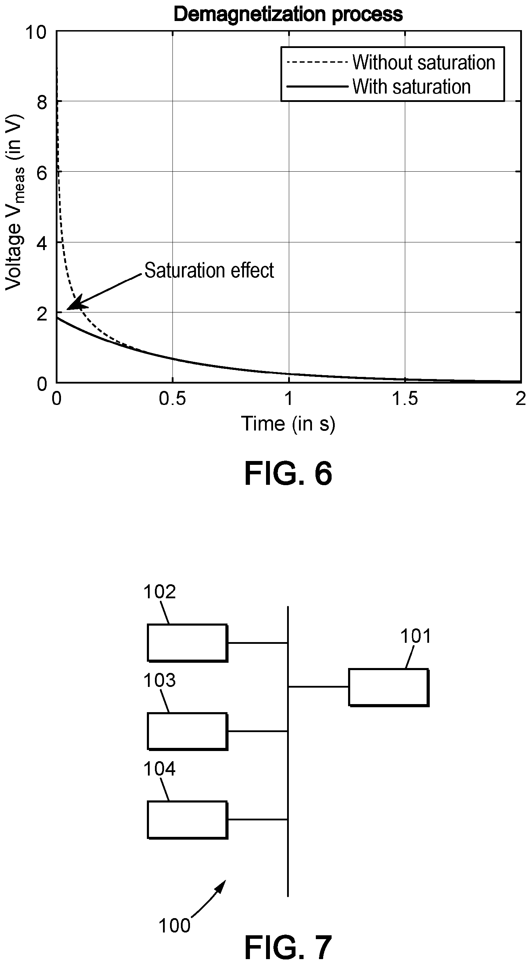

Figure 6 shows a voltage-time curve that illustrates a demagnetization process of a motor magnetic core. The exemplary curve of Fig. 6 showing the evolution of the measured voltage over time during demagnetization of the magnetic core of the motor.

Fig. 6 shows an exemplary demagnetization curve for the following parameters of the exemplary induction motor model and exemplary magnetic saturation model discussed herein: $\gamma = 0.3$, $\varphi_\infty = 1.3\ Wb$, $L_0 = 250\ mH$, $R_r = 500\ m\Omega$, and for an initial magnetic flux value of $\varphi(0) = 1.17\ Wb$.

As shown by Fig. 6, a magnetic saturation effect of the magnetic core of the motor may be reflected in the beginning of the demagnetization process of the core as the magnetic core may have reached its saturation level during the magnetization process. As a consequence, the measured voltage may decrease linearly over time from an initial value, whereas it would exponentially decrease over time without saturation of the magnetic core, as illustrated by Fig. 6.

As shown on Fig. 6, the saturation effect is reflected on the measured voltage for an initial period of time of approximately half a second ($t_{sat} \approx 0.5s$), whereas the measured voltage may accurately reflect the demagnetization process without saturation afterwards (from $t_{sat}$ to the end of the demagnetization of the core). That is, assuming that the demagnetization process lasts a given demagnetization duration ($\Delta t_{Demag}$ being equal to approximately 2 seconds in the example illustrated by Fig. 6), the saturation effect occurring during magnetization of the magnetic core may be reflected in the voltage measurement part performed the early part of the demagnetization duration ($\Delta t_{Demag}$) (from $t = 0$ to $t = t_{sat}$ in the example of Fig. 6), while it would no longer be present in a voltage measurement part performed for the rest of the demagnetization process (from $t_{sat}$ to the end of $\Delta t_{Demag}$).

The present subject disclosure advantageously exploits the fact that the magnetic saturation of the core is reflected in the voltage measurement only for an early portion of the demagnetization process, while the voltage decreases according to an exponential decay curve reflecting demagnetization after the end of the early portion and until the end of the demagnetization process. Two successive time periods of the demagnetization process can therefore be distinguished with respect to presence of the magnetic saturation effect reflected in the voltage measurement: a first, initial, time period at the beginning of demagnetization during which it can be considered that the measured voltage is impacted by the magnetic saturation of the core, and a second, subsequent, time period following the first time period until the end of demagnetization during which it can be considered that the measured voltage is no longer impacted by the magnetic saturation of the core. In the following, the first time period may be referred to as "first time period showing saturation", while the second time period may be referred to as "second time period without saturation."

In one or more embodiments, instead of using the integration method until the end of the demagnetization process, that is, until the end of the demagnetization duration ($\Delta t_{Demag}$), which would require performing the voltage measurement by collecting voltage measurement data points for the entire demagnetization duration ($\Delta t_{Demag}$) in order to estimate the initial magnetic flux of the magnetic core by integrating the value of the measured induced voltage until the end of the demagnetization process (e.g. integrating the collected voltage data points over the entire demagnetization duration ($\Delta t_{Demag}$)), the integration method may be used only during the first time period showing saturation.

In some embodiments, the integration method may be used on a voltage measurement that is only performed during a voltage measurement period during initial demagnetization of the magnetic core of the motor. The voltage measurement period during which the voltage measurement is performed may be preconfigured to correspond to the specific first time period showing saturation of the motor on which the voltage measurement is performed. As a consequence, the voltage measurement may advantageously not be performed until the end of the demagnetization process, but instead only during a voltage measurement period which corresponds to an initial portion of the demagnetization process, and is shorter than the entire demagnetization process.

In some embodiments, the voltage measurement may be configured to be started during an initial phase of the demagnetization process (at an early stage of demagnetization), and to end before the end of the demagnetization process. The voltage measurement may therefore result in voltage measurement data points covering only an initial portion of the demagnetization process (at an early stage of demagnetization).

As a consequence, the integration method applied on the voltage measurement (data points) may result in integrating the measured induced voltage over a period of time spanning an initial time at which the voltage measurement starts to the end of the voltage measurement period, instead of integrating the measured voltage until the end of demagnetization.

Depending on the embodiments, the voltage at the motor's terminals may or not be measured until the end of the demagnetization process, so that voltage measurement data points that may have been acquired after the end of the voltage measurement period may be disregarded for purposes of applying the integration method. As a consequence, only the voltage measurement data points acquired during the voltage measurement period may be used for purposes of applying the integration method.

Referring back to Fig. 6, using only voltage measurement data points acquired during a voltage measurement period configured during initial demagnetization of the magnetic core of the motor (at an early stage of the demagnetization process of the core) for applying the integration method is advantageous in that it avoids applying such integration method to voltage values which, because the reflect a latter part until the end of the demagnetization of the core, may be low and subject to unprecise measurements depending on the measurement equipment used for performing the voltage measurement (for example in cases where a standard-grade voltage measurement equipment with limited accuracy performances for low voltage values is used). Indeed, performing the voltage measurement with limited accuracy would generate errors when applying the integration method which may build up during the magnetic decaying, with a resulting error which is proportional to the integration duration. An advantage of the proposed scheme is therefore to avoid using the integration method over an integration duration which is too long in that it uses measured data points that correspond to the early stage of the demagnetization and therefore may not suffer from measurement errors that would be detrimental to the accuracy of the estimate obtained with the integration method. By using the integration method only on voltage measurement data points captured during an initial part (early stage) of the demagnetization process, the captured values can be considered high enough so that measurement errors are avoided, or at least reduced, even in cases of using a standard-grade measurement equipment.

In one or more embodiments, because the integration method is used only on the voltage measurement data points acquired during a voltage measurement period which is shorter than the entire demagnetization process duration, it may result in a magnetic flux estimate which is a component of the magnetic flux that would be estimated if the integration method had been applied over the entire demagnetization process duration. As a consequence, a first magnetic flux estimate component may be determined based on the voltage measurement, for example by using the integration method applied to voltage measurement data points acquired during the voltage measurement period.

In some embodiments, the integration method may be used for integrating the voltage measurement over the voltage measurement period, in order to integrate the value of the measured voltage induced by the demagnetization until the end of the voltage measurement period, which advantageously falls before the end of the demagnetization process.

In some embodiments, the measurement of the voltage for the voltage measurement period may comprise a plurality of $S$ voltage measurement data points $(v_i)_{1 \leq i \leq S}$, $S$ being a non-zero natural integer, and one or more of the plurality of $S$ voltage measurement data points $(v_i)_{1 \leq i \leq S}$ may be integrated in order to obtain the first magnetic flux estimate component.

For example, in embodiments where the $S$ voltage measurement data points $(v_i)_{1 \leq i \leq S}$ are obtained through measurement sampling with a sampling interval $(\Delta t)$, the first magnetic flux estimate component may be determined based on a combination of the sampling interval with a combination of one or more of the $S$ voltage measurement data points $(v_i)_{1 \leq i \leq S}$, such as, for example, the combination $\Delta t \cdot \sum_{i=1}^{S} v_i$.

According to the present subject disclosure, a second method, other than the integration method, may be used for determining the portion of the initial magnetic flux which is not accounted for by integrating the induced voltage only on a portion of the demagnetization process duration. In one or more embodiments, a regression method (e.g. an exponential regression method) may be used for that purpose. Using an exponential regression method is advantageous in the exemplary context of the present subject disclosure focusing on the demagnetization process of the magnetic core of an induction motor in that such demagnetization process typically follows an exponential decaying profile, such as the one illustrated by Fig. 6.

As discussed above, during the demagnetization process, the magnetic flux in the motor magnetic core may be governed by the following differential equation:

$$0 = R_r \frac{\varphi(t)}{L_0} \frac{1 - \gamma \frac{\varphi(t)}{\varphi_\infty}}{1 - \left(\frac{\varphi(t)}{\varphi_\infty}\right)^2} + \frac{d\varphi}{dt}(t)$$

In some embodiments, small values of magnetic flux ($\varphi(t) \ll \varphi_\infty$) may be considered in order to approximate the magnetization as linear, thereby leading to the following simplified formulation of the above differential equation:

$$0 = R_r \frac{\varphi(t)}{L_0} + \frac{d\varphi}{dt}(t)$$

as $1 - \gamma \frac{\varphi(t)}{\varphi_\infty} \approx 1$ and $1 - \left(\frac{\varphi(t)}{\varphi_\infty}\right)^2 \approx 1$.

The following function $\varphi_a(t)$ is a solution to the above simplified equation:

$$\varphi_a(t) = \varphi_a(t')e^{-\frac{t-t'}{\tau_0}}$$

where $\tau_0 = \dfrac{L_0}{R_r}$ is the rotor time constant of the rotor of the motor operating in linear regime. The magnetic flux of the magnetic core of an injection motor may therefore decrease exponentially during demagnetization, the exponential decrease being governed by a time constant $\tau_0$ that corresponds to the rotor time constant of the rotor of the motor operating in linear regime.

In one or more embodiments, using the exponential regression method may involve fitting an exponential decreasing curve on the voltage measurement data points acquired during the voltage measurement period.

A second magnetic flux estimate component can then advantageously be deduced mathematically from the resulting fitted parameters.

Use of the exponential regression method is advantageous because this method is immune from measurement errors as it forces the voltage curve to fit a perfect exponential curve. However, the exponential regression method assumes magnetic linearity and tends to perform badly under magnetic saturation.

The exponential regression method is therefore a good complement to the integration method as it performs well for voltage measurement values for which the integration method does not (as the integration method is sensitive to measurement errors potentially made when measuring small voltage values at the end of the demagnetization process), and vice versa (as the exponential regression method leads to errors during the initial (early) phase of demagnetization where magnetic saturation of the magnetic core is present).

Therefore, in some embodiments, the integration method may be used for determining a first magnetic flux estimate component based on a voltage measurement performed only on a portion of the demagnetization process of the magnetic core of an induction motor, and the exponential regression method may be used for determining a second magnetic flux estimate component which, combined with the first magnetic flux estimate component, will provide an estimate of the magnetic flux of the magnetic core at the start of demagnetization.

In one or more embodiments, an estimate of the rotor time constant $\tau_0$ of the rotor of the motor operating in linear regime may be determined based on the voltage measurement for purpose of applying the exponential regression method:

In one or more embodiments, an exponential regression may be used to estimate a value of a time constant of the rotor of the motor operating in linear regime based on the voltage measurement.

Referring back to Fig. 5b, the voltage $V_{meas}$ measured at the motor's terminals during demagnetization of the magnetic core (magnetic inductance component $L$ on Fig. 5b) of the motor may reflect such demagnetization through the following exponential decrease over time:

$$V_{meas}(t) = V_0 e^{-\frac{t}{\tau_0}}$$

where $V_0$ is a measured voltage value at $t = 0$, and $\tau_0$ is the time constant of the rotor of the motor.

As shown on Fig. 6, the magnetic core of the motor may experience magnetic saturation for initial measurements of the voltage (in the example of the figure, for a duration of measurement inferior to 0.3 to 0.5 second). Past an initial duration of measurement ($0 \leq t \leq t_{sat\_threshold}$), the voltage measurement performed corresponds to a linear regime of the motor (that is, without magnetic saturation of the magnetic core).

In one or more embodiments, the measurement of the voltage for the voltage measurement period may generate a plurality of $S$ voltage measurement data points $(v_i)_{1 \leq i \leq S}$, $S$ being a non-zero natural integer. In some embodiments, the $S$ voltage measurement data points $(v_i)_{1 \leq i \leq S}$ are obtained through measurement sampling with a sampling interval ($\Delta t$). Therefore, in some embodiments, $S$ duplets of voltage measurement data point $v_i$ and acquisition time $t_i$ of the corresponding voltage measurement data point $v_i$ within the voltage measurement period may be generated through the plurality of $S$ voltage measurement data points $(v_i)_{1 \leq i \leq S}$ comprised in the voltage measurement of the voltage at motor terminals of the motor at standstill during the (initial) part of demagnetization of the magnetic core of the motor. In some embodiments, the voltage measurement period may correspond to the time interval $t_s - t_1$. In some embodiments, the plurality of $S$ data points $(t_i, v_i)_{1 \leq i \leq S}$ may be determined based on the voltage measurement.

In some embodiments, in order to estimate the value of the rotor time constant during linear magnetization, an exponential regression may be applied, preferably once the voltage is linear (during the linear regime of the motor) - for example for the second time period without saturation - as the exponential regression may use a linear regression algorithm applied on the log ($v_i$) data.

In order to use an exponential regression on a data set, in some embodiments, the logarithm of one or more of the data of the data set, e.g. one or more of the plurality of $S$ voltage measurement data points $(v_i)_{1 \leq i \leq S}$ may be determined, in order to apply a linear regression algorithm.

In some embodiments, one may then consider a set of $S$ time-voltage data points to be exponentially fitted: $(t_i, v_i)_{1 \leq i \leq S}$, with an exponential relation between the time duration $t_i$ and the voltage variable $v_i$, such as for example:

$$v_i = V_0 e^{-\frac{t_i}{\tau_0}}$$

where $V_0$ is an initial voltage measurement value (at $t = 0$), and $\tau_0$ is a time constant.

Taking the logarithm of $v_i$ leads to:

$$\log(v_i) = \log(V_0) - \frac{t_i}{\tau_0}$$

In some embodiments, a linear regression may therefore be applied to the log data set $(t_i, \log v_i)_{1 \leq i \leq N}$, for example using the following equations:

$$\log \hat{V}_0 = \frac{\sum t_i \sum t_i \log v_i - \sum t_i^2 \sum \log v_i}{(\sum t_i)^2 - N \sum t_i^2}$$

and

$$-\frac{1}{\hat{\tau}_0} = \frac{\sum t_i \sum \log v_i - N \sum t_i \log v_i}{(\sum t_i)^2 - N \sum t_i^2}$$

Therefore, in some embodiments, an estimate $\hat{\tau}_0$ of the rotor time constant $\tau_0$ may be determined based on the following:

$$\hat{\tau}_0 = -\frac{(\sum t_i)^2 - N \sum t_i^2}{\sum t_i \sum \log v_i - N \sum t_i \log v_i}$$

The dominance of the demagnetization process phase where the inner core is under linear magnetization (which, as shown on Fig. 6, follows a short magnetic saturation phase of the core) over such magnetic saturation phase will minimize the impact of having some data points which may be chosen from slightly before the full entry in the magnetic linear zone, which advantageously confers a stronger robustness to the estimate of the rotor time constant according to embodiments of the proposed scheme.

In one or more embodiments, the second magnetic flux estimate component may be determined based on the estimate $\hat{\tau}_0$ of the rotor time constant by combining such estimate with c selected in the neighborhood of the last voltage measurement point ($v_S$). The one or more voltage measurement data points of the plurality of $S$ voltage measurement data points $(v_i)_{1 \leq i \leq S}$ may be selected based on that they correspond to a switching time within the demagnetization process period from use of the integration method to use of the exponential regression method (e.g. to a transition time between the first time period showing saturation and the second time period without saturation).

For example, in some embodiments, the second magnetic flux estimate component may be determined by combining the estimate $\hat{\tau}_0$ of the rotor time constant with the last voltage measurement point ($v_S$), e.g. based on the product $\hat{\tau}_0 \cdot v_S$, as the last voltage measurement point ($v_S$) may in some embodiments correspond to a switching time within the demagnetization process period from use of the integration method to use of the exponential regression method (e.g. to a transition time between the first time period showing saturation and the second time period without saturation).

Therefore, in one or more embodiments, a method switching time ($t_{st}$) may be considered, which corresponds to a switching time within the demagnetization process period from use of the integration method to use of the exponential regression method (e.g. to a transition time between the first time period showing saturation in which the integration is applied, and the second time period without saturation in which the exponential regression is applied). In some embodiments, the method switching time ($t_{st}$) may correspond to $S\Delta t$, where S is the number of voltage measurement data points acquired during the voltage measurement period, and $\Delta t$ is the sampling period for acquisition of the voltage measurement data points).

In one or more embodiments, the method switching time may be a parameter of the proposed method configured (determined) based on a primary estimate of the rotor time constant. Such primary estimate of the rotor time constant of the induction motor may be provided by the manufacturer of the motor in the data sheet of the motor. Therefore, in embodiments where the voltage measurement for the voltage measurement period comprises a plurality of $S$ voltage measurement data points $(v_i)_{1 \leq i \leq S}$, the number $S$ of voltage measurement data points $(v_i)_{1 \leq i \leq S}$ to be acquired during demagnetization of the magnetic core of the motor may be chosen based on the primary estimate of the rotor time constant, for example based on a multiple of the primary estimate of the rotor time constant (e.g. 2 or 3 times the primary estimate of the rotor time constant).

In some embodiments, the integration method may be applied to voltage measured from the beginning of the demagnetization process up to the method switching time ($t_{st}$), and a first magnetic flux estimate may be determined based on results of the integration method, and the exponential regression method may be used to determine a second magnetic flux estimate component that corresponds to the demagnetization of the core from the method switching time ($t_{st}$) to the end of the demagnetization.

In one or more embodiments, the second magnetic flux estimate component may be determined based on one or more voltage measurement data points of the plurality of $S$ voltage measurement data points $(v_i)_{1 \leq i \leq S}$ (e.g. based on the last voltage measurement point $v_S$), or based on an average voltage value ($\tilde{v}_S$) averaging a plurality of voltage measurement data points of the plurality of $S$ voltage measurement data points $(v_i)_{1 \leq i \leq S}$ (for example selected in the neighborhood among the plurality of $S$ voltage measurement data points $(v_i)_{1 \leq i \leq S}$ of the last voltage measurement point ($v_S$)).

In some embodiments, each of the plurality of voltage measurement data points selected for determining the average voltage value may be comprised in a set of $\{v_{S+k}\}_{-2K \leq k \leq 0}$, wherein $K$ is a non-zero natural integer. In some embodiments, an average voltage value ($\tilde{v}_S$) averaging a plurality of voltage measurement data points of the plurality of $S$ voltage measurement data points $(v_i)_{1 \leq i \leq S}$ may be determined, for example according to the following formula:

$$\tilde{v}_S = \frac{1}{2K} \sum_{-2K \leq k \leq 0} v_{S+k}$$

This average voltage value may in some embodiments provide an average voltage value at the method switching time ($t_{st}$).

In one or more embodiments, the voltage measurement at terminals of the motor at standstill may be performed during a preconfigured voltage measurement period and may be pursued for some time after expiry of the voltage measurement period. For example, voltage measurement data points may still be acquired after the end of the preconfigured voltage measurement period. In some embodiments, voltage measurement data points acquired after the end of the preconfigured voltage measurement period may be used to calculate an average voltage value at the method switching time ($t_{st}$), for example according to the following formula:

$$\tilde{v}_S = \frac{1}{2K} \sum_{-K \leq k \leq K} v_{S+k}$$

Using an average value advantageously allows rejecting high-frequency noise measurements and provides a better representative value of the voltage at the instant of the demagnetization process corresponding to the method switching time ($t_{st}$).

In one or more embodiments, the second magnetic flux estimate component may be determined by combining the estimate $\hat{\tau}_0$ of the rotor time constant with the average voltage value at the method switching time ($\tilde{v}_s$), e.g. based on the product $\hat{\tau}_0 \cdot \tilde{v}_S$.

Therefore, in some embodiments, the exponential regression method may provide an estimate $\hat{\tau}_0$ of the rotor time constant, and such estimate may be combined with a voltage value corresponding to the method switching time, such as, in some embodiments, an average voltage value corresponding to the method switching time.

In one or more embodiments, an estimate $\hat{\varphi}$ the magnetic flux of the magnetic core of the motor after magnetization (e.g. resulting from a DC injection) may be determined based on the following formula:

$$\hat{\varphi} = \Delta t \sum_{i=1}^{S} v_i + \hat{\tau}_0 \tilde{v}_S$$

where $\hat{\tau}_0$ is an estimate of a time constant of the rotor of the motor, S is the number of voltage measurement data points $(v_i)_{1 \leq i \leq S}$ obtained through voltage measurement sampling with a sampling interval ($\Delta t$), and $\tilde{v}_S$ is an average voltage value at a method switching time configured based on $S \cdot \Delta t$. For example, the average voltage value $\tilde{v}_S$ may be determined based on the following formula:

$$\tilde{v}_S = \frac{1}{2K} \sum_{-K \le k \le K} v_{S+k}$$

or, depending on the embodiment, based on the following formula:

$$\tilde{v}_S = \frac{1}{2K} \sum_{-2K \le k \le 0} v_{S+k}$$

Therefore, advantageously, according to the present subject disclosure, in order to benefit from each of the advantages of both the integration method and the exponential regression method, the proposed scheme advantageously uses the integration method at the beginning of the demagnetization process of the magnetic core, where magnetic saturation is most likely occurring, and then, after a preconfigured time interval, switches to the exponential regression method to account for the remaining flux of the demagnetization process. This hybridization offers a number of benefits. For example, errors are less likely to accumulate and become non-negligible because the integration method is not used for a time as long as the entire demagnetization process. In addition, observing that the saturation effect is influencing only for a multiple of (e.g., the first one to two times) the rotor time constant, the integration method will take into account this effect, and the remaining part of the voltage signal can be more trustfully considered as exponentially decreasing and then, be processed more efficiently by the exponential regression method. Finally, because the flux can be easily calculated mathematically once the parameters of the exponential curve are accurately estimated, the exponential regression advantageously allows estimating the flux before the measured voltage completely decays which makes the proposed method time-saving.

A primary estimation of the rotor time constant may advantageously be used to set the parameter for the switching instant between these two methods.

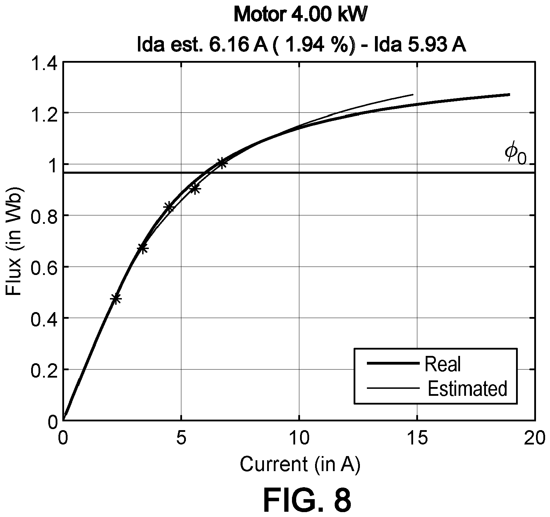

Figure 8 illustrates an exemplary motor drive apparatus 100 configured to use features in accordance with embodiments of the present subject disclosure.

The motor drive apparatus 100 may include a control engine 101, a motor drive engine 102, motor interface engine 103, a memory 105, and a power supply (e.g., a battery, plug-in power supply, etc.) (not represented on the figure). The motor drive apparatus may be configured with a data communication interface (not represented on the figure) configured for coupling the apparatus to an induction motor (through one or more motor terminals of the motor) for driving the induction motor through the data communication interface (not represented on the figure), and/or with an electrical signal interface for electrical coupling of the apparatus 103 with an induction motor (through one or more motor terminals of the motor).

In the architecture illustrated on Fig. 8, all of the motor drive engine 102, motor interface engine 103, and memory 104 are operatively coupled with one another through the control engine 101.

In one or more embodiments, the motor drive engine 102 is configured to perform various aspects of embodiments of the proposed methods for configuring a motor drive as described herein. For example, in some embodiments, the motor interface engine 103 may be configured to determine, based on N voltage measurements voltage at motor terminals of the induction motor at standstill performed during demagnetization of the magnetic core of the induction motor, an estimate of the magnetic inductance component of the motor operating in linear regime, determine, based on one of the N voltage measurements, an estimate of a time constant of the rotor of the motor operating in linear regime, and determine an estimate of a rotor resistance of the motor based on the estimates of the magnetic inductance component of the motor and the rotor time constant.

In one or more embodiments, the motor interface engine 103 is configured to manage one or more of a data communication interface and electrical signal interface with the motor in situations where the motor drive apparatus 100 is coupled to a motor to be driven. For example, in some embodiments, the motor interface engine 103 may be configured to perform a plurality of N measurements of a voltage at motor terminals of the motor at standstill during demagnetization of the magnetic core of the motor.

The control engine 101 includes a processor, which may be any suitable microprocessor, microcontroller, Field Programmable Gate Arrays (FPGA), Application Specific Integrated Circuits (ASIC), Digital Signal Processing chip, and/or state machine, or a combination thereof. According to various embodiments, one or more of the computers can be configured as a multi-processor computer having multiple processors for providing parallel computing. The control engine 101 may also comprise, or may be in communication with, computer storage media, such as, without limitation, the memory 104, capable of storing computer program instructions or software code that, when executed by the processor, causes the processor to perform the elements described herein. In addition, the memory 104 may be any type of data storage computer storage medium, capable of storing a data structure representing a computer network to which the motor drive apparatus 100 belongs, coupled to the control engine 101 and operable with the motor interface engine 103 and the motor drive engine 102 to facilitate management and processing of data stored in association therewith.

In embodiments of the present subject disclosure, the motor drive apparatus 100 is configured for performing the methods described herein.

It will be appreciated that the motor drive apparatus 1 shown and described with reference to Fig. 8 is provided by way of example only. Numerous other architectures, operating environments, and configurations are possible. Other embodiments of the node may include fewer or greater number of components, and may incorporate some or all of the functionality described with respect to the motor drive apparatus components shown in Fig. 8. Accordingly, although the control engine 101, motor drive engine 102, motor interface engine 103, and memory 104 are illustrated as part of the motor drive apparatus 100, no restrictions are placed on the location and control of components 102-- 104. In particular, in other embodiments, components 102-- 104 may be part of different entities or computing systems.

Depending on the embodiment, the apparatus 100 may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

Performances of the proposed method are illustrated by Fig. 9, which shows a flux vs current curve of a real motor and an estimated flux vs current curve using the proposed scheme. As shown in Fig. 9, using a real test bench, the proposed method gives a magnetizing curve which is very close to the real one. In Fig. 9, the horizontal line indicates the nominal flux that needs to be applied when the motor is controlled. The "Ida" notation (which designates the nominal fluxing current of the motor) refers to the magnetizing current that generates the nominal flux. In the performance test illustrated on the figure, 5 DC injections were made and 5 corresponding flux values were estimated. The saturation model is then fitted on these 5 points and the resulting magnetizing curve is shown in the bold line. The other curve shows the real magnetizing curve. We can notice a 2% error in the magnetizing current Ida with respect to the peak-to-peak nominal current 11.88 A.

In addition, several motors were used to evaluate the performance of the proposed method and compare it to a standard rotational tune technique. A reference value of Ida was obtained by rotating the motor with no load. Results are reported in the following Table 1 from which we can see the proposed method's low error value, which provides a performance level comparable to the rotational tune but with a lot fewer restrictions because the proposed method does not call for mechanical decoupling of the motor.

**Table 1:**

| Motor power | Reference | Ida TNR | Ida TUN | Error TNR | Error TUN |
|---|---|---|---|---|---|
| 1,5 kW | 2,1 A | 1,86 A | 1,94 A | 3,28 % | 2,23 % |
| 4,0 kW | 6,35 A | 5,93 A | 6,16 A | 3,56 % | 1,60 % |
| 7,5 kW | 10,21 A | 9,54 A | 10,82 A | 3,33 % | 3,07 % |
| 15 kW | 14,51 A | 14,05 A | 14,98 A | 1,18 % | 1,20 % |
| 55 kW | 52,41 A | 50,92 A | 52,64 A | 1,05 % | 0,16 % |

While the invention has been described with respect to preferred embodiments, those skilled in the art will readily appreciate that various changes and/or modifications can be made to the invention without departing from the spirit or scope of the invention as defined by the appended claims.

Although this invention has been disclosed in the context of certain preferred embodiments, it should be understood that certain advantages, features and aspects of the systems, devices, and methods may be realized in a variety of other embodiments. Additionally, it is contemplated that various aspects and features described herein can be practiced separately, combined together, or substituted for one another, and that a variety of combination and sub-combinations of the features and aspects can be made and still fall within the scope of the invention. Furthermore, the systems and devices described above need not include all of the modules and functions described in the preferred embodiments.

Information and signals described herein can be represented using any of a variety of different technologies and techniques. For example, data, instructions, commands, information, signals, bits, symbols, and chips can be represented by voltages, currents, electromagnetic waves, magnetic fields or particles, optical fields or particles, or any combination thereof.

Depending on the embodiment, certain acts, events, or functions of any of the methods described herein can be performed in a different sequence, may be added, merged, or left out all together (e.g., not all described acts or events are necessary for the practice of the method). Moreover, in certain embodiments, acts or events may be performed concurrently rather than sequentially.

**Claims**

1. A method for driving an induction motor comprising a rotor and a magnetic core comprising a magnetic inductance component, the method comprising, by a motor drive configured for interfacing with the induction motor:

   performing a voltage measurement at terminals of the motor at standstill for a voltage measurement period during initial demagnetization of the magnetic core of the motor from an initial magnetic flux of the magnetic core, wherein the voltage measurement period is shorter than a time period of complete demagnetization of the magnetic core from the initial magnetic flux;
   determining a first magnetic flux estimate component based on the voltage measurement;
   determining a second magnetic flux estimate component by performing an exponential regression algorithm on the voltage measurement; and
   determining an estimate of the initial magnetic flux based on the first magnetic flux estimate component and the second magnetic flux estimate component.

2. The method according to claim 1, further comprising: configuring the motor drive based on the estimate of the initial magnetic flux.

3. The method according to any of the preceding claims, further comprising: determining an estimate ($\hat{\tau}_0$) of a time constant of the rotor of the motor using the exponential regression algorithm, wherein the second magnetic flux estimate component is determined based on the estimate ($\hat{\tau}_0$) of the time constant of the rotor of the motor.

4. The method according to claim 3, wherein the measurement of the voltage for the voltage measurement period comprises a plurality of $S$ voltage measurement data points ($v_i$)$_{1\leq i\leq S}$, $S$ being a non-zero natural integer, and wherein the second magnetic flux estimate component is determined based on a combination of the estimate ($\hat{\tau}_0$) of the time constant of the rotor of the motor with one or more voltage measurement data points of the plurality of $S$ voltage measurement data points ($v_i$)$_{1\leq i\leq S}$ selected in the neighborhood of the last voltage measurement point ($v_S$).

5. The method according to any of the preceding claims, wherein the measurement of the voltage for the voltage measurement period comprises a plurality of $S$ voltage measurement data points ($v_i$)$_{1\leq i\leq S}$, $S$ being a non-zero natural integer, the method further comprising: determining an average voltage value ($\tilde{v}_S$) averaging a plurality of voltage measurement data points of the plurality of $S$ voltage measurement data points ($v_i$)$_{1\leq i\leq S}$, wherein the second magnetic flux estimate component is determined based on the average voltage value.

6. The method according to claim 5, wherein each of the plurality of voltage measurement data points is comprised in a set of $\{v_{S+k}\}_{-K\leq k\leq 0}$, wherein K is a non-zero natural integer.

7. The method according to any of the preceding claims, wherein the measurement of the voltage for the voltage measurement period comprises a plurality of $S$ voltage measurement data points ($v_i$)$_{1\leq i\leq S}$, $S$ being a non-zero natural integer, the method further comprising: determining an average voltage value ($\tilde{v}_S$) averaging a plurality of voltage measurement data points of the plurality of S voltage measurement data points ($v_i$)$_{1\leq i\leq S}$ by:

$$\tilde{v}_S = \frac{1}{2K} \sum_{-K\leq k\leq K} v_{S+k}$$

wherein the second magnetic flux estimate component is based on the average voltage value $\tilde{v}_S$.

8. The method according to any of the preceding claims, wherein the measurement of the voltage for the voltage measurement period comprises a plurality of $S$ voltage measurement data points ($v_i$)$_{1\leq i\leq S}$, $S$ being a non-zero natural integer, wherein the $S$ voltage measurement data points ($v_i$)$_{1\leq i\leq S}$ are obtained through measurement sampling with a sampling interval ($\Delta t$), and wherein the first magnetic flux estimate component is determined based on a combination of the sampling interval with a combination of one or more of the $S$ voltage measurement data points ($v_i$)$_{1\leq i\leq S}$.

9. The method according to claim 8, wherein the first magnetic flux estimate component is determined based on the combination $\Delta t \cdot \sum_{i=1}^{S} v_i$.

10. The method according to any of the preceding claims, wherein the measurement of the voltage for the voltage measurement period comprises a plurality of $S$ voltage measurement data points $(v_i)_{1 \leq i \leq S}$, $S$ being a non-zero natural integer, the method further comprising: determining an estimate $(\hat{\tau}_0)$ of a time constant of the rotor of the motor using the exponential regression algorithm, wherein the $S$ voltage measurement data points $(v_i)_{1 \leq i \leq S}$ are obtained through voltage measurement sampling with a sampling interval $(\Delta t)$, wherein the first magnetic flux estimate component is determined based on the combination $\Delta t \cdot \sum_{i=1}^{S} v_i$ , wherein the second magnetic flux estimate component is determined based on the combination $\hat{\tau}_0 \bar{v}_S$, wherein the voltage value $\bar{v}_S$ is determined based on one or more voltage measurement data points of the plurality of S voltage measurement data points $(v_i)_{1 \leq i \leq S}$ selected in the neighborhood of the last voltage measurement point $(v_S)$; and wherein the estimate of the initial magnetic flux is determined based on combination of the first magnetic flux estimate with the second magnetic flux estimate component.

11. The method according to any of the preceding claims, wherein the measurement of the voltage for the voltage measurement period comprises a plurality of $S$ voltage measurement data points $(v_i)_{1 \leq i \leq S}$, $S$ being a non-zero natural integer, and wherein the integer $S$ is predefined based on a multiple of a primary estimate of the rotor time constant.

12. The method according to any of the preceding claims, wherein the motor is an asynchronous induction motor.

13. An apparatus, the apparatus comprising a processor, a memory operatively coupled to the processor, and an interface for coupling to an induction motor to be driven by the apparatus, wherein the apparatus is configured to perform a method according to any of claims 1 to 12.

14. A computer program product comprising computer program code tangibly embodied in a computer readable medium, said computer program code comprising instructions to, when provided to a computer system and executed, cause said computer to perform a method according to any of claims 1 to 12.

15. A data set representing, for example through compression or encoding, a computer program product according to claim 14.

**FIG. 1**

**FIG. 2**

10

11

performing a voltage measurement at terminals of the motor
at standstill for avoltage measurement period
during initial demagnetizationof the magnetic core of
the motor from an initial magnetic flux of the magnetic core

12

determining a first magnetic flux estimate component based
on the voltage measurement

13

determining a second magnetic flux estimate component
by performing an exponential regression algorithm
on the voltage measurement

14

determining an estimate of the initial magnetic flux based on
the first magneticflux estimate and the second magnetic flux
estimate component

# FIG. 3

FIG. 4

FIG. 5a

FIG. 5b

## Demagnetization process

FIG. 6

FIG. 7

FIG. 8

Europäisches
Patentamt

European
Patent Office

Office européen
des brevets

# EUROPEAN SEARCH REPORT

**Application Number**

EP 23 30 6791

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 4 670 698 A (FULTON DONALD E [US] ET AL) 2 June 1987 (1987-06-02) * the whole document * ----- | 1-15 | INV. H02P21/14 H02P21/16 |
| A | KR 100 732 512 B1 (LS IND SYSTEMS CO LTD [KR]) 27 June 2007 (2007-06-27) * the whole document * ----- | 1-15 | |
| X | EP 2 270 522 B1 (ABB OY [FI]) 30 May 2012 (2012-05-30) | 1-3, 12-15 | |
| A | * the whole document * ----- | 4-11 | |

**TECHNICAL FIELDS SEARCHED (IPC)**

H02P

The present search report has been drawn up for all claims

| Place of search | Date of completion of the search | Examiner |
|---|---|---|
| Munich | 25 March 2024 | Wimböck, Thomas |

EPO FORM 1503 03.82 (P04C01)

## ANNEX TO THE EUROPEAN SEARCH REPORT
## ON EUROPEAN PATENT APPLICATION NO.

EP 23 30 6791

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2024

| Patent document cited in search report | | Publication date | Patent family member(s) | | Publication date |
|---|---|---|---|---|---|
| US 4670698 | A | 02-06-1987 | NONE | | |
| KR 100732512 | B1 | 27-06-2007 | NONE | | |
| EP 2270522 | B1 | 30-05-2012 | CN | 101944878 A | 12-01-2011 |
| | | | EP | 2270522 A1 | 05-01-2011 |
| | | | US | 2011010116 A1 | 13-01-2011 |

EPO FORM P0459

For more details about this annex : see Official Journal of the European Patent Office, No. 12/82